# EUROPEAN PATENT APPLICATION

(11) **EP 2 871 780 A2**
(43) Date of publication of application: **13.05.2015**
(21) Application number: 14192911.7
(22) Date of filing: 13.06.2008
(51) Int. Cl.: H04B 1/707, H04B 1/7117, H04B 1/7115, H03M 1/12, H03M 1/00

(54) **System and methods for controlling modem hardware**

(30) Priority: 15.06.2007 US 763769
(62) Divisional of application: 08770955.6
(71) Applicant: Qualcomm Incorporated, San Diego, CA 92121-1714 (US)
(72) Inventor: Soliman, Samir S., San Diego, CA California 92121-1714 (US); Rajkotia, Amol, San Diego, CA California 92121-1714 (US)
(74) Representative: Skrba, Sinéad

(57) **Abstract**

Systems and methods are provided for minimizing power consumption in a wireless mobile device. In one embodiment, a computer implemented method is provided that facilitates utilization of resources of a mobile device. This includes identifying available resources of a device and dynamically disabling or enabling subsets of the resources as a function of at least a channel estimation

## Description

### BACKGROUND

### I. Field

The subject technology relates generally to communications systems and methods, and more particularly to systems and methods that selectively turn on and off resources in a mobile communications device in order to minimize power consumption in the device.

### II. Background

When signals are transmitted from base station to receivers in a wireless network, various types of signal processing systems may be applied to reconstruct an accurate and high fidelity signal that may have arrived at the receiver impaired by multiple path effects. One such system for processing the respective paths is known as a Rake receiver which can also be part of a wireless transmitter/receiver system referred to as a modem (modulator/demodulator). Another example is the equalizer. In general, Rake receivers employ several base band correlators to individually process several signal multi-path components in a concurrent manner. The correlator outputs are then combined to achieve improved communications reliability and performance. On the other hand, the equalizer estimates the impulse response of the radio channel and based on the estimate removes the effects of the channel on the transmitted signal.

In many applications, both the base station and mobile receivers use Rake receiver techniques for communications, where each correlator in a Rake receiver is deemed a Rake-receiver finger. The base station combines the outputs of its Rake-receiver fingers non-coherently, whereby the outputs are added in power. The mobile receiver generally combines its Rake-receiver finger outputs coherently, where the outputs are added in voltage. Typically mobile receivers and base stations utilize several fingers in their receivers.

Rake based estimators are commonly employed for channel estimation in single-carrier systems. In such a system, "fingers" are assigned to the dominant paths in the channel. The channel magnitude for each finger is then typically computed by correlation with an appropriately delayed version of a pilot PN sequence, wherein the sequence refers to a pair of modified maximal length PN (Pseudorandom Noise) sequences utilized to spread quadrature components of a channel. An averaging filter can be employed on this channel estimate to trade-off channel estimation accuracy with Doppler tolerance, wherein the filter generally applies a finger management algorithm for assignment, de-assignment, and tracking, of the respective signal components processed at the respective fingers.

Power consumption is an important consideration for battery operated wireless modems that employ some of the Rake techniques described above. Generally, power budget analysis indicates that power consumption is not symmetric and thus, the receiver of the modem generally consumes more power than the transmitter side of the modem and hence, the resources it uses to process received samples is an important factor in determining the overall power consumption and how long the device battery will last. Different sections in the modem such as analog baseband, digital baseband and radio frequency (RF) portions consume different powers. For short range devices, the baseband receive section is an important factor to consider for the power budget. The receiver is generally designed with a fixed number of resources such as Rake fingers, equalizer taps, A-to-D converter (ADC) bits, and so forth based on certain metrics such as energy per bit to thermal noise density (Eb/No), Received Signal Strength Indicator (RSSI), Block Error Rate (BLER), Packet Error Rate (PER), Signal-to-Noise-Ratio (SNR), Link Quality Indicator (LQI), Bit Error Rate (BER), and so forth or any other metrics derived from these examples, to maintain certain quality-of-service (QoS) in various channels. One problem in managing power beforehand is to guarantee a desired QoS. This commitment often consumes additional power in the receiver however.

### SUMMARY

The following presents a simplified summary of various embodiments in order to provide a basic understanding of some aspects of the embodiments. This summary is not an extensive overview. It is not intended to identify key/critical elements or to delineate the scope of the embodiments disclosed herein. Its sole purpose is to present some concepts in a simplified form as a prelude to the more detailed description that is presented later.

Systems and methods are provided for dynamically controlling resources and minimizing power consumption in a wireless mobile device. A resource manager monitors various parameters of a mobile wireless device such as signal-to-noise ratio (SNR), channel estimation, quality-of-service (QoS), and so forth to determine a respective threshold for such parameters. Depending on the threshold or other resource utilization considerations, various components within the wireless mobile device can be selectively turned on or off to minimize power consumption in the device. For example, it may be determined from a channel estimation that the QoS for a given device based upon its current location can be met with less resources. Thus, it may be possible for the resource manager to disable one or more resources or components within the device in order to conserve power in the device. As QoS or other signal quality degrades, the resource manager can dynamically enable components as desired to facilitate that a desired service quality is maintained. In this manner, by selectively and dynamically controlling resources as communications circumstances dictate, power consumption in the device can be conserved thus facilitating such aspects as improving battery life in the device. In one specific application, dynamic controls can be applied to ultra wideband systems which generally require low power consumption. Similarly, dynamic resource management can be applied substantially to any type of wireless mobile device.

To the accomplishment of the foregoing and related ends, certain illustrative embodiments are described herein in connection with the following description and the annexed drawings. These aspects are indicative of various ways in which the embodiments may be practiced, all of which are intended to be covered.

### BRIEF DESCRIPTION OF THE DRAWINGS

Fig. 1 is a schematic block diagram illustrating a wireless network system having dynamic resource controls for controlling power consumption.
Fig. 2 is a diagram that illustrates a link adaptive receiver control for wireless devices.
Fig. 3 is a schematic block diagram of an adaptive Rake receiver.
Fig. 4 is a schematic block diagram of an adaptive equalizer.
Fig. 5 is diagram illustrating threshold processing for an adaptive receiver.
Figs. 6-8 illustrate example channel type waveforms that are processed by an adaptive receiver.
Fig. 9 is a diagram illustrating resource allocation table processing.
Fig. 10 is a flow diagram that illustrates an adaptive receiver control process.
Fig. 11 is a diagram illustrating logical modules for an adaptive receiver system.
Fig. 12 is a diagram illustrating an example transceiver set for an ultra wideband wireless system.

### DETAILED DESCRIPTION

Systems and methods are provided for minimizing power consumption in a wireless mobile device. In one embodiment, a computer implemented method is provided that facilitates utilization of resources of a mobile device. This includes identifying available resources of a device and dynamically disabling or enabling subsets of the resources as a function of at least a channel estimation to improve or optimize performance of the device. Various components of the mobile device can be improved or optimized for dynamic power consumption controls including an adaptive Rake receiver, adaptive filter taps, cluster finger managers, word length managers, sampling managers, equalizer tap managers, and other components. Although examples may be provided showing ultra wideband configurations, the embodiments described herein can be applied to any code division multiple access (CDMA) system. Also, certain example metrics are described herein for controlling power. These metrics can include but are not limited to the following list that includes energy per bit to thermal noise density (Eb/No), Received Signal Strength Indicator (RSSI), Block Error Rate (BLER), Packet Error Rate (PER), Signal-to-Noise-Ratio (SNR), Link Quality Indicator (LQI), Bit Error Rate (BER), and so forth. It is to be appreciated when any of these metrics are discussed that the other metrics appearing in this list (or others not on the list) may also be employed along with the described metric for controlling power and desired service.

As used in this application, the terms "component," "network," "system," and the like are intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a communications device and the device can be a component. One or more components may reside within a process and/or thread of execution and a component may be localized on one computer and/or distributed between two or more computers. Also, these components can execute from various computer readable media having various data structures stored thereon. The components may communicate over local and/or remote processes such as in accordance with a signal having one or more data packets (*e.g.,* data from one component interacting with another component in a local system, distributed system, and/or across a wired or wireless network such as the Internet). It is further noted that terms such as minimize can be read as minimize or reduce. Similarly, terms such as maximize can be read as maximize or increase, whereas terms such as optimize can be read as optimize or improve.

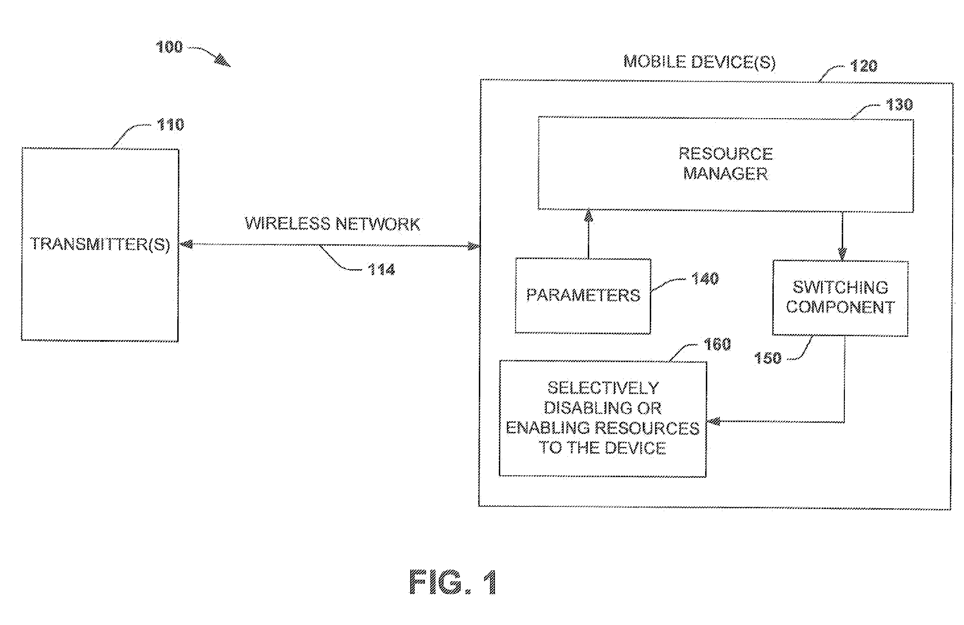

**Fig. 1** illustrates a wireless network system 100 having dynamic resource controls for managing system resources to minimize power consumption. The system 100 includes one or more transmitters that communicate across a wireless network 114 to one or more mobile devices 120. Such devices 120 can include modem (modulator/demodulator), transceivers, hand held devices, computerized devices and so forth that communicate data across the network 114. A resource manager 130 is provided to dynamically monitor and manage power within the device 120. Power conservation is related to monitoring a plurality of parameters 140 in the device 120 and utilizing one or more switching components 150 to selectively disable or enable device resources at 160. The parameters 140 can include various inputs or data that define the desired operating conditions of the device 120. For example, such parameters 140 can include signal or data thresholds, quality of service (QoS) conditions, channel estimation information, signal to noise ratio (SNR) information, resource utilization tables, and/or other feedback conditions for the resource manager 130 that indicate a minimum number of resources that should be enabled at 160 in order to conserver power in the device 120.

In general, the system 100 supports a link adaptive receiver architecture that utilizes hardware (or software) resources in the device 120 in an optimum or suitable manner to minimize power consumption. The architecture can be applied to but not limited to, a direct sequence spread spectrum type ultra wideband (UWB) communication systems, for example. An example usage for UWB systems is in high speed local connectivity in vehicle, home and office type networks. Another usage of UWB systems is in very low data rate sensor networks. Some attributes of the UWB device are low energy consumption and hence extended battery life, where the large bandwidth of UWB systems includes components operating at very high speeds thereby, consuming significant power if ran continuously without proper management. Another characteristic of the UWB system is that it operates using a fixed transmit power. In such systems, dynamically adjusting the receiver parameters in an intelligent manner based on channel conditions results in significant power savings of the device 120.

As noted above, the system 100 is not limited to UWB devices and such dynamic power conservation principles can be applied to substantially any mobile device 120. The following description will now illustrate various components of the link adaptive architecture noted above. Such components include a Link Adaptive Receive Control, an Adaptive Rake Receiver, Adaptive Filter Taps, a Cluster Finger Manager, an Analog to Digital (ADC) Wordlength Manager, an ADC Sampling Manager, and an Equalizer Tap Manager which are described in more detail below.

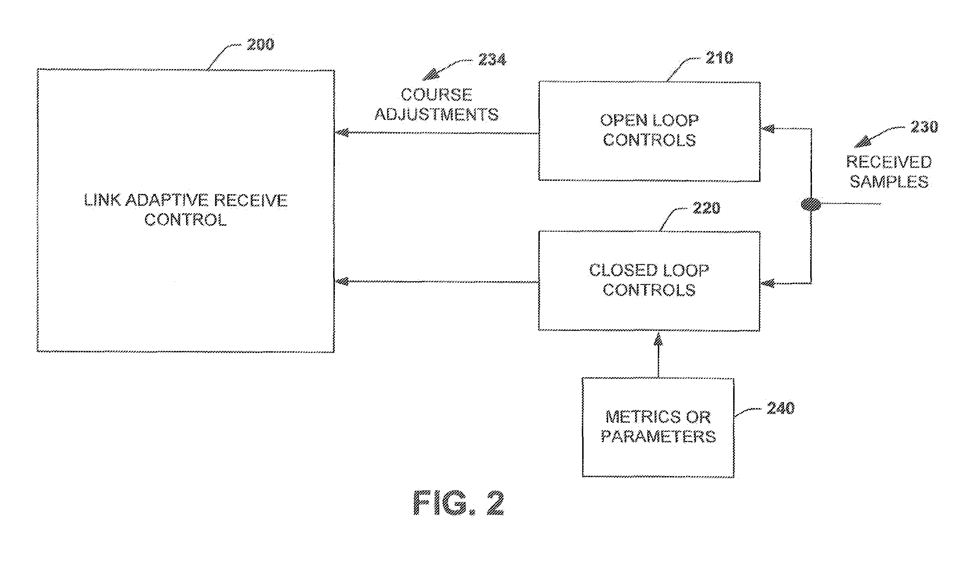

**Fig. 2** illustrates a Link Adaptive Receive Control (LARC) 200 for wireless devices. As illustrated, the LARC includes open loop controls 210 and/or closed loop controls 220, wherein the respective controls process received samples 230. Generally, a device can be placed in different types of environments resulting in different channel conditions between the transmitter and receiver that are more benign than conditions used in designing the receiver. As a result, it may not be necessary to use all the resources to achieve the desired quality of service (QoS). The extra link budget margin can be used to disable one or more resources to minimize the power consumption. An aspect of the Link Adaptive Receive Control 200 is to minimize the power consumption while maintaining the desired QoS under different channel conditions.

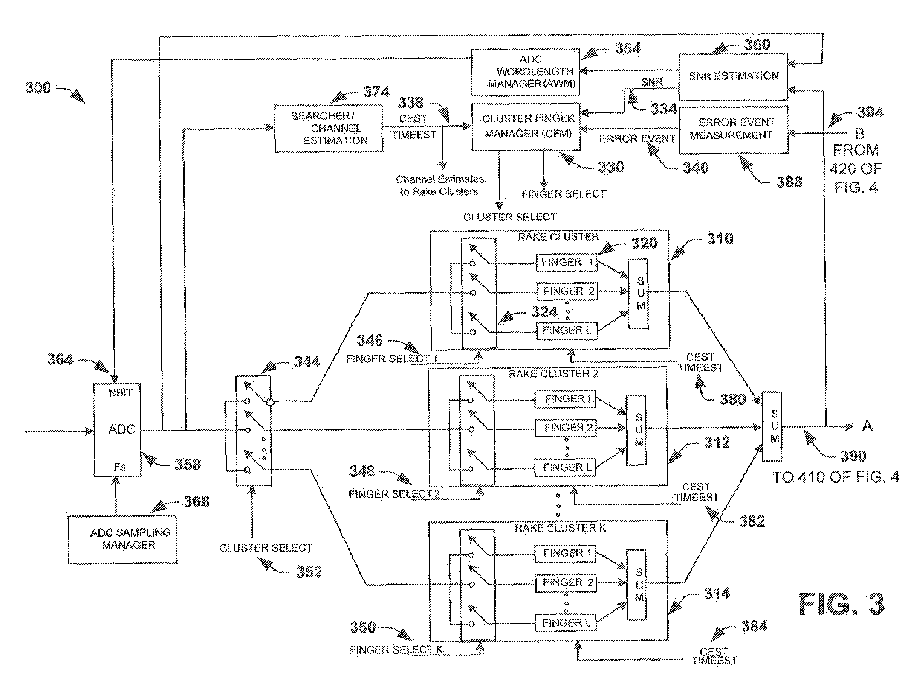

The LARC 200 can apply Open Loop and/or Closed Loop controls 210 and 220, respectively. Under Open Loop conditions, the LARC 200 measures the signal-to-noise ratio (SNR) of the incoming received samples 230 and performs a course adjustment of device resources at 234. The open loop control reduces the power consumption to some extent and exceeds the desired QoS requirement. Under Closed Loop conditions, the LARC 200 uses the SNR along with other metrics or parameters 240 such as PER to refine resource utilization and to further minimize the power consumption while achieving and maintaining the desired QoS. It is to be appreciated that other metrics such as RSSI, Eb/No, BLER, and so forth can be employed to perform resource adaptation in this manner. Before proceeding, it is noted that the open loop controls 210 and/or the closed loop controls 220 can be employed within the LARC 200 or outside the LARC as shown. The controls 210 and 220 can be associated with various resource control components that are illustrated in more detail with respect to Fig. 3 below. For example, such control components that can employ open or closed loop methods include cluster finger managers, analog to digital control (ADC) word length managers, ADC sampling clock managers, equalizer tap managers and other control components as will be described in more detail below.

**Fig. 3** is illustrates an example block diagram of an adaptive Rake receiver 300 that can employ open or closed loop resource control processes that were previously described above with respect to Fig. 2. In dense multi-path environments as experienced in very wide bandwidth channels for example, the number of Rake resources increases significantly. This increase in Rake resources directly translates to increase in complexity and power consumption. The receiver shown at 300 groups Rake resources into several clusters (K) 310-314 with each cluster including several fingers (L) such as shown at 320, for example, with K and L being positive integers. Switching logic 324 permits enabling or disabling of individual clusters and also, enabling or disabling individual fingers within a given cluster. Optimum or suitable switching of clusters and fingers within clusters 310-314 results in significant power savings and extends the battery life of the device. The overall architecture results in a channel dependent Rake receiver. In an Additive White Gaussian channel where there is typically only a single path, the control logic would reduce the Rake architecture to a single finger, for example. In another case where there is unity processing gain in the system, a single finger would be used and the symbols would be sent to an equalizer engine (not shown) for further processing. In systems employing large processing gains, the extra gain and link margin could be used to further minimize Rake resources requirements.

A cluster finger manager 330 (CFM) determines the optimum or suitable number of Rake clusters to use and number of fingers within a cluster to use to achieve the desired demodulation performance. The number of clusters is determined based on estimated SNR, channel estimation or time estimation 336, or probability of demodulation error event 340 or any combination of these including parameters derived or equivalent to these. For example, the optimum or suitable cluster and fingers within a cluster could also be determined based on the channel conditions or acquisition result. As shown, switching logic 344 is provided to select a desired number of cluster resources, where FINGER_SELECT control signals from the CFM 330 are shown at 346-350 and cluster select controls at 352. It is noted that the outputs shown at 336 can include one or more output signals. In this example, output 336 includes channel estimate data or signals and time estimate data or signals.

At 354, an ADC Wordlength Manager (AWM) is provided. The AWM 354 determines the optimum or suitable word length (number of bits) for an analog to digital converter (ADC) 358 based on the estimate of the received signal-to-noise ratio at 360. The power consumption of the ADC 358 is proportional to the number of bits used. Significant power savings can be achieved by scaling the ADC 358 word length based on the required signal-to-noise ratio 360 or other channel conditions. It is noted that channel conditions can include an estimated SNR, a channel estimation, a probability of demodulation error event, or any combination of these or other channel condition/parameter derived or equivalent to these. A favorable channel condition could be used to reduce the word length of the ADC 358. Based on the received SNR 360, the AWM 354 produces a control signal NBIT 364 that indicates the number of bits to be used by the ADC. This signal is then used to control the ADC word length. In systems employing large processing gains i.e., larger symbol times, the extra gain and link margin could be used to minimize the ADC 358 word length requirements.

At 368, an ADC Sampling Manager (ASM) is provided. A common method of processing the received waveform is to sample it at a rate equal to at least two times the significant bandwidth. For large bandwidths as is in UWB systems, the sampling rate of the A-to-D converter 358 can be large resulting in higher power consumption. The over-sampling of the signal by two or more provides a means to adjust for timing errors due to mismatch between the transmitter and receiver. The continuous or periodic adjustment of timing is useful in rapidly varying channels. However, in stationary channels and with packet sizes much smaller than the channel coherence time, the timing can be adjusted at the beginning of the packet during a preamble/pilot period and then kept constant during the rest of the packet. In such a scenario, the received waveform can be over-sampled during the preamble portion where the timing is adjusted. After that time, the remaining portion of the packet can be sampled at the correct time using a rate of one times the signal bandwidth thus, providing power savings directly proportional to the reduction in over-sampling. For example, changing the sampling rate from Fs to Fs/2 can result in a savings of up to 50% in power consumption.

In time varying channels or when the transmitted packet duration is larger than the channel coherence time, it may be necessary to adjust the timing during the preamble portion as well as periodically during the remainder of the packet. In such scenarios, the sampling rate can be increased to the desired value to provide the timing adjustments. The ADC Sampling Manager 368 determines the appropriate sampling rate using information such as channel conditions, portion of the packet that is being processed, and so forth. As illustrated a searcher and channel estimation component 374 can be provided to provide output channel estimations and/or time estimations at 336, which are employed as channel estimation and/or time estimation inputs by the fingers of the K clusters at 380-384. An error event measurement component is illustrated at 388 and generates error event 340 discussed above. It is noted that in an alternative embodiment, output 340 from the error event measurement component 388 can be employed as input to the AWM 354 which can serve as a further control of ADC word length at 364.

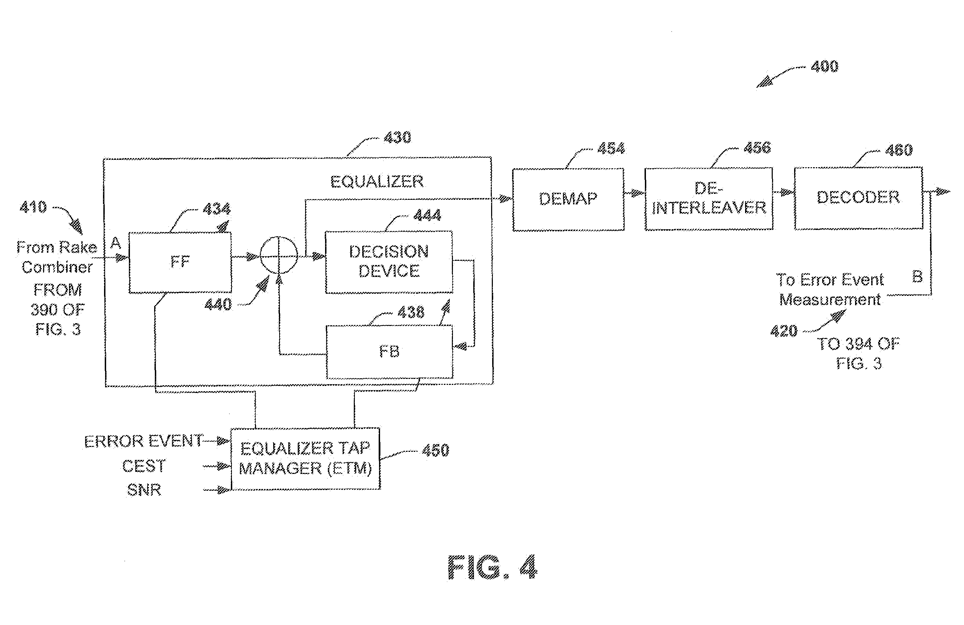

**Fig. 4** is illustrates example schematic block diagram of an adaptive equalizer system 400. The system 400 receives input 410 from reference numeral 390 of Fig. 3 and provides an output 420 to reference numeral 394 of Fig. 3. In certain channel conditions, a Rake receiver may not be the optimum solution in view of higher data rates where inter-symbol interference (ISI) is dominant. In such cases, it is desirable to implement an equalizer 430. The equalizer 430 is generally implemented as a digital filter with N taps, where each filter tap has a delay unit, multiply unit and a summing unit all clocked at the input symbol rate. These three units have significantly long word lengths and thus, consume a lot of power due to their high speed operation. Significant reduction in power consumption can be achieved by disabling these units.

In this example, an architecture is provided that permits the adjustment of taps based on channel conditions and demodulation performance. Under favorable channel conditions, the number of taps can be reduced, thus reducing the power consumption and extending the battery life of the device. A symbol rate decision feedback equalizer having variable forward taps 434 and feedback taps 438 is introduced. The taps 434 and 438 can be adjusted based on channel conditions or data rates. For example, a longer channel, i.e., one with a larger delay spread, may need more feedback taps than a channel with shorter delay spread. Another example is when the adjustment of taps is based on the processing gain, i.e., number of chips per symbol. In the limiting case of unity processing gain, the symbol rate out of the Rake combiner at 410 is the same as the chip rate. In this case, the Rake block shown in Fig. 3 can utilize a single finger and the equalizer 430 can run at the chip rate. As shown, the equalizer may also include a summing component 440 and a decision device 444.

An Equalizer Tap Manager (ETM) 450 determines an optimum or suitable number of equalizer taps to use to achieve the desired demodulation performance. The number of equalizer taps can be determined based on channel conditions such as estimated SNR, channel estimation, probability of demodulation error event, or any combination of these or other parameter derived or equivalent to these. For example, the optimum or suitable number of taps could be determined based on the channel delay parameters such as mean and RMS delay spreads that are estimated from the channel estimation algorithm. For a linear equalizer, the ETM 450 can adjust the number of feed-forward (FF) taps 434 while disabling the feedback (FB) taps 438 and decision device 444. For a non-linear equalizer such as a decision feedback equalizer (DFE), the ETM 450 can adjust both the feed-forward (FF) taps 434 and feedback (FB) taps 438. In systems employing large processing gains, i.e., lower data rates, the symbol times are longer and hence, the equalizer requirement can be reduced. Based on the data rate and channel conditions, the ETM 450 determines the number of equalizer taps to use to meet the target performance while minimizing the power consumption. Other components in the system 400 can include a de-map component 454, a de-interleaver component 456, and a decoder 460.

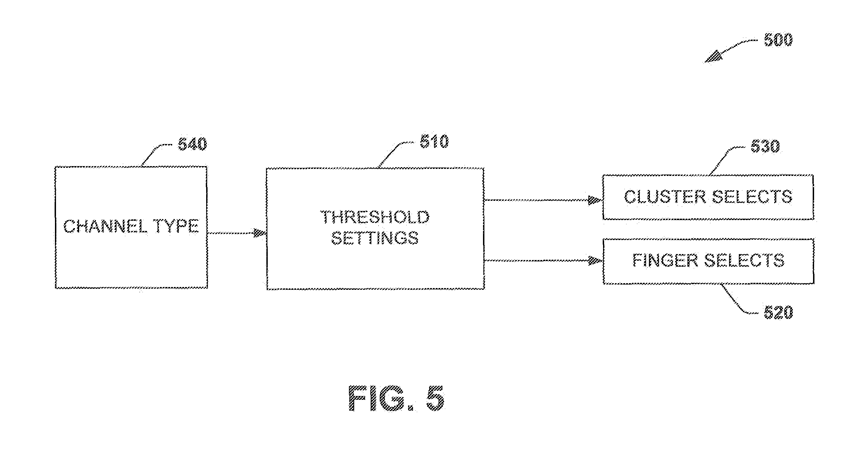

**Fig. 5** illustrates a system 500 that processes one or more threshold conditions for an adaptive receiver. An assumption can be made that the receiver applies a threshold at 510 and assigns fingers 520 to paths within (T) dB of the strongest. As shown, clusters may also be assigned at 530 in view of the threshold 510 where a channel type is analyzed at 540. Also, consider that transmit waveform can be shaped by a square root raised cosine filter with roll-off r (any other filter could be used).

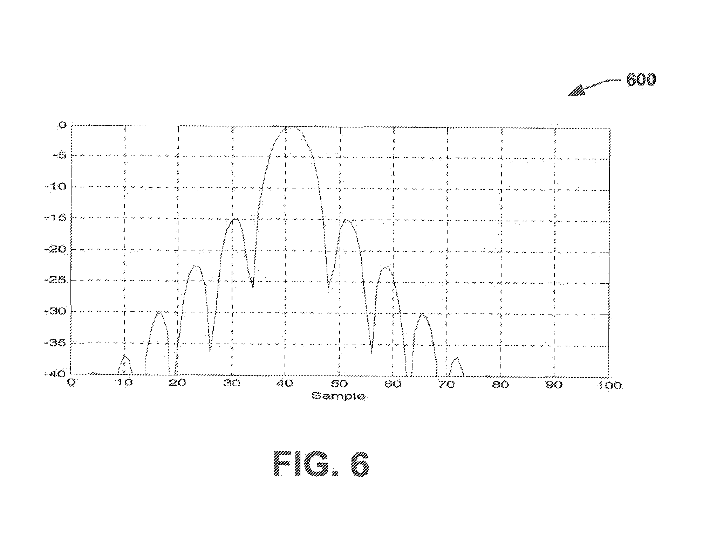

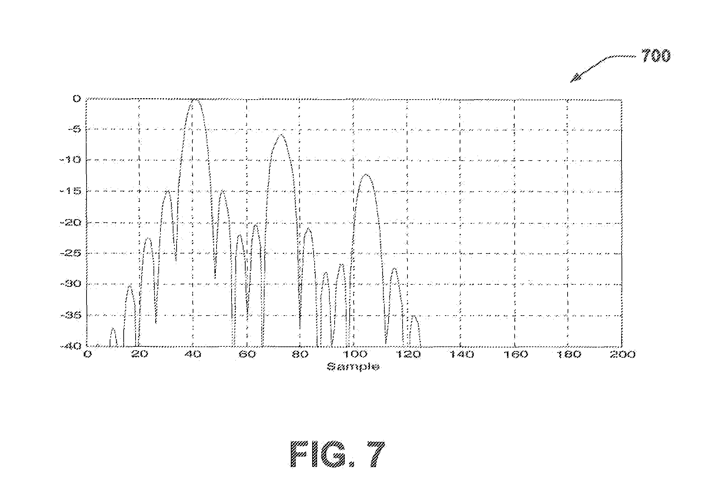

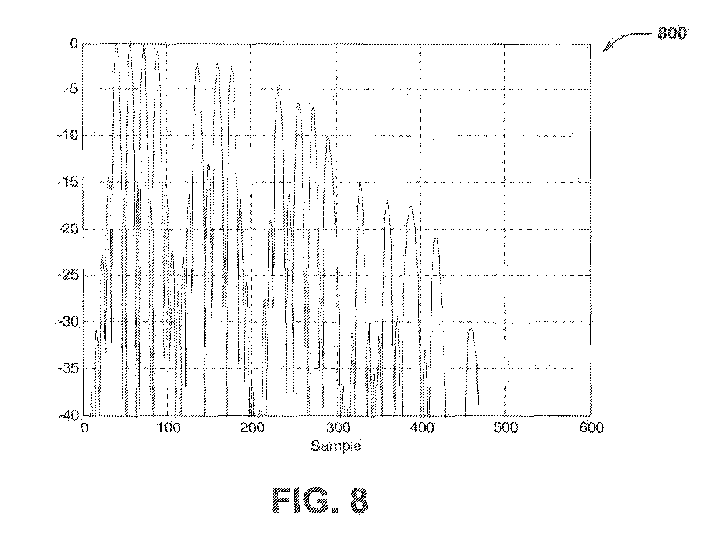

Figures 6-8 illustrate example channel types and waveforms that can be processed by the system 500 in Fig. 5, where differing finger assignments can be employed based on the respective channel types. For a signal received via a Line of Sight (LOS) channel (See e.g., waveform 600 of **Fig. 6****)** and after selecting paths within T-dB where T could be chosen as 14dB for example, there can be a single finger assignment. In another example, a signal received via a sparse multipath channel comprising 3-paths (See e.g., waveform 700 of **Fig. 7****)** is considered. After applying the T dB thresholding, 3 fingers can be assigned, for example. In another example, consider a signal transmission through a dense multipath channel (See e.g., waveform 800 of **Fig. 8****).** Applying a 14dB thresholding at 510 of Fig. 5 above, close to 12 paths may be observed.

Depending on the channel conditions as determined by the Channel Estimation/Searcher unit (shown at 374 of Fig. 3), the results of the fingers assignments at 520 of Fig. 5 can be conveyed to the CFM (shown at 330 of Fig. 3) to enable or disable the finger resources. In an example, assume that the Rake structure is organized into 8 clusters with 3 fingers per cluster (could be organized in various other configurations as well). Thus, for the LOS channel, the CFM would set CLUSTER_SELECT to select the 1st cluster and a single finger within that cluster. For the 3-path channel, the CFM would set CLUSTER_SELECT to select the entire 1st cluster. For the dense multipath channel, the CFM would set the CLUSTER_SELECT to select entire clusters 1, 2, and 3. In all these examples, the unused clusters and unused fingers within a used cluster can be powered-down thus providing significant power savings. It is to be appreciated that other channel types and/or significant paths can be similarly processed as the examples discussed herein. A time and frequency tracking element is generally provided for each Rake finger to enable the finger to appropriately track the time and frequency drift of a specific multipath component. In sparse channels as shown in 700 of Fig 7, where the paths could be significantly separated in time, having the ability to individually track these components is desirable. However, in dense multipath channels as shown in 800 of Fig 8, the paths could arrive in clusters. In such scenarios, having a single tracking element within a cluster to track the entire cluster provides significant power savings since each individual Rake finger need not have its tracking elements powered-on.

**Table 1: Significant Paths for different channels**

| **e.g., Channel Type** | **e.g., Significant Paths** |
|---|---|
| LOS | 1 |
| 3-path | 3 |
| Dense Multipath | 12 |

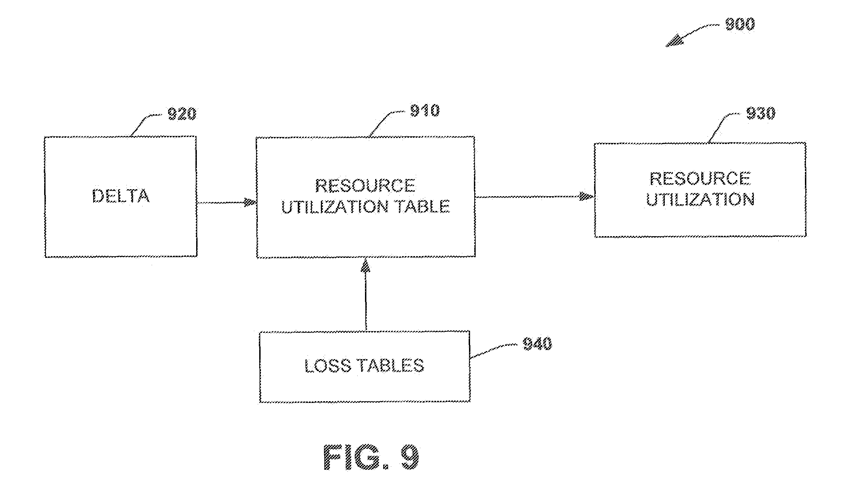

**Fig. 9** is a system 900 illustrating resource allocation table processing. Although a channel may have several significant multipaths that could all be used by the receiver, utilizing all of them may not be necessary. In favorable channel conditions where the received SNR is higher than normal, the receiver disables some of the Rake resources. The SNR estimation unit (shown at 360 of Fig. 3) determines the received signal to noise ratio and conveys it to the CFM (shown at 330 of Fig. 3) which uses it to determine the optimum or suitable number of Rake resources to use. The CFM computes the difference between the reported SNR (MeasuredSNR) and the operating SNR (TargetSNR) and uses it to map it to the number of resources required based on a resource utilization table (RUT) shown at 910.

The input of the RUT 910 is Delta shown at 920 and the output is the resource utilization at 930 with an example shown below in Table 2. The resources could be Rake fingers, ADC bits, equalizer taps or a combination of these resources. More than one combination of resources can yield the same performance or target SNR. In such scenarios, the CFM selects the appropriate combination to minimize the modem power consumption. The RUT 910 can be generated based on one or more loss tables such as a Rake Loss Table (RLT), ADC Loss Table (ALT) and the Equalizer Loss Table (ELT) shown in example Tables 3-5 below. The RLT provides the SNR loss when using reduced number of fingers relative to the maximum number of fingers. The ALT provides the SNR loss when using reduced number of ADC bits relative to the maximum number of bits. The ELT provides the SNR loss when using reduced number of equalizer taps relative to the maximum number of taps. Each of these tables: RLT, ALT and ELT can be generated a priori based on prior channel measurements and simulations. These tables can then be updated during the course of modem operation to generate more precise estimates of the SNR loss while operating with different resource utilizations.

**Table 2: Example Resource Utilization Table (RUT)**

| **Delta (dB)** | **Resources [Fingers,ADC Bits]** |
|---|---|
| 0 | [32,4] |
| 0.5 to1.5 | [16,3], [32,2] |
| 1.5 to 2.5 | [32,1], [16,2], |
| 2.5 - 3.5 | [16,1], [8,3] |

**Table 3: Example Rake Loss Table (RLT)**

| | **4 fingers** | **8 fingers** | **16 fingers** | **32 fingers** |
|---|---|---|---|---|
| Predicted energy capture loss (relative to 32 fingers) | 3.8 dB | 2.3 dB | 0.9 dB | 0dB |

**Table Error! No text of specified style in document.: Example ADC Loss Table (ALT)**

| | **1-bit ADC** | **2-bit ADC** | **3-bit ADC** | **4 bit ADC** |
|---|---|---|---|---|
| **Observed SNR loss (relative to floating point**) | **2dB** | **0.6 dB** | **0.2dB** | **0dB** |

**Table 4: Example Equalizer Loss Table (ELT)**

| | **5-taps** | **10-taps** | **15-taps** | **20-taps** |
|---|---|---|---|---|
| **Observed SNR loss (relative 20 taps)** | **1.5dB** | **0.5 dB** | **0.2dB** | **0dB** |

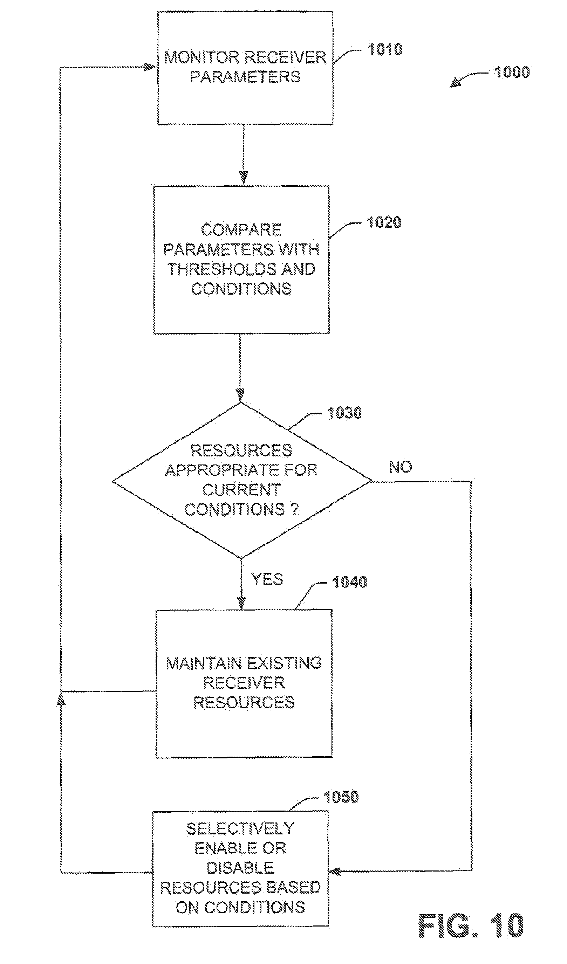

**Fig. 10** illustrates an adaptive receiver control processes for wireless devices. While, for purposes of simplicity of explanation, the methodology is shown and described as a series or number of acts, it is to be understood and appreciated that the processes described herein are not limited by the order of acts, as some acts may occur in different orders and/or concurrently with other acts from that shown and described herein. For example, those skilled in the art will understand and appreciate that a methodology could alternatively be represented as a series of interrelated states or events, such as in a state diagram. Moreover, not all illustrated acts may be required to implement a methodology in accordance with the subject methodologies disclosed herein.

Proceeding to 1010, one or more parameters or metrics are monitored in an adaptive receiver. As noted previously, these can include signal to noise ratios (SNRs), channel estimation information, error event data, and other conditions within a receiver that may indicate signal quality and so forth. In addition, alternative aspects include selectively enabling or disabling resources based upon auxiliary or policy aspects associated with the device and these aspects can be monitored in addition to the parameters or metrics previously described. For example, a user may set certain policies or circumstances that can be automatically detected that determine when one or more resources can be disabled. This can include employment of intelligent components such as classifiers to learn respective patterns associated with a device. These may include setting or detecting usage patterns for the device and disabling resources accordingly (e.g., after 1:00AM maintain minimal resources for emergencies only).

At 1020, the parameters described above are compared with one or more threshold conditions. These can include dynamically updatable resource tables that define such conditions. Also, electronic or data settings can be maintained within the device to define a plurality of thresholds that may be used to determine when to enable or disable resources in view of the given threshold. At 1030, a determination is made as to whether or not one or more resources are adequately enabled in view of current operating conditions for the receiver. For example, an SNR monitor may be compared to an SNR threshold that defines the number of Rake clusters and/or fingers that should be enabled in view of the currently detected SNR. As can be appreciated, a plurality of thresholds can be compared in this manner. If resource utilization is currently adequate at 1030, the process proceeds to 1040 where current resources are maintained in the receiver and then the process returns to 1010 and continues to monitor receiver parameters. If resource utilization is not currently adequate at 1030, the process proceeds to 1050. At 1050, one or more device resources are selectively enabled or disabled depending on the comparison at 1030. For example, if excellent SNR conditions were detected, one or more device resources may be disabled to conserve power. Conversely, if poor signal conditions were detected, one or more device resources may be enabled in order to facilitate a desired quality of service at the receiver. When suitable resources have been enabled or disabled at 1050, the process proceeds back to 1010 and monitors receiver parameters.

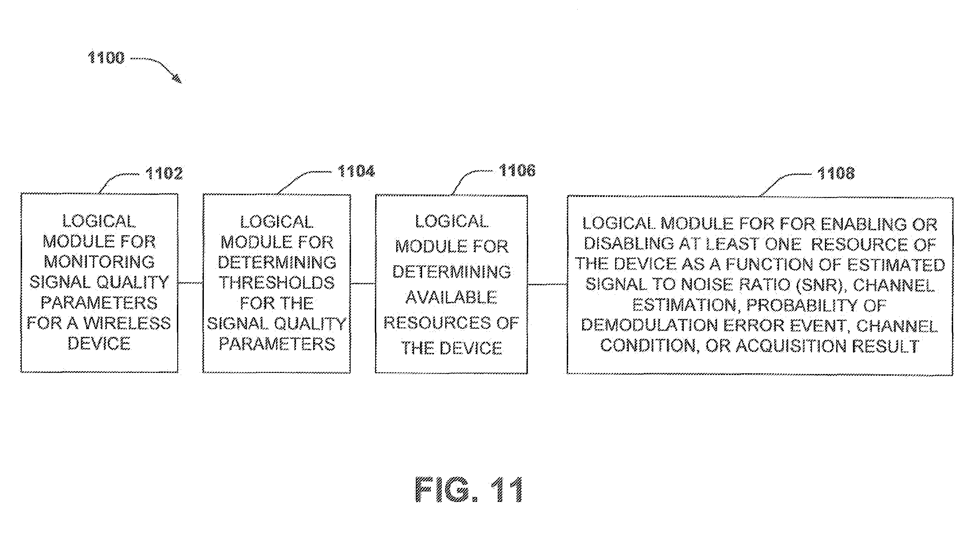

**Fig. 11** is a system 1100 providing logical modules for an adaptive receiver. In an embodiment, the system 1100 is applied to a wireless communications system. This includes a logical module 1102 for monitoring signal quality parameters for a wireless device. As noted previously, parameters can include SNR, channel estimation data, other signal quality data, and so forth. At 1104, a logical module is provided for determining thresholds for the signal quality parameters. This can include employment of one or more resource allocation or utilization tables to determine such thresholds. At 1106, a logical module for determining available resources of the device is provided. This can include components that monitor feedback in the device to determine available channel conditions. At 1108, a logical module for enabling or disabling at least one resource of the device is provided. This enabling or disabling can be a function of an estimated signal to noise ratio (SNR), a channel estimation, a probability of demodulation error event, a channel condition, or an acquisition result, for example. Other embodiments include determining resource utilization of the wireless device based on signal quality parameters and the determined thresholds. This can include processing resources to compare a selected signal quality parameter and a given threshold to determine if more or less resources are needed for a given communications condition. Upon determining the signal quality parameters and the thresholds, resources can be switched on or off within the wireless device in view of the signal quality parameters and the determined thresholds. The switching resources can include software controls and/or electronic controls for enabling or disabling a selected resource within the device.

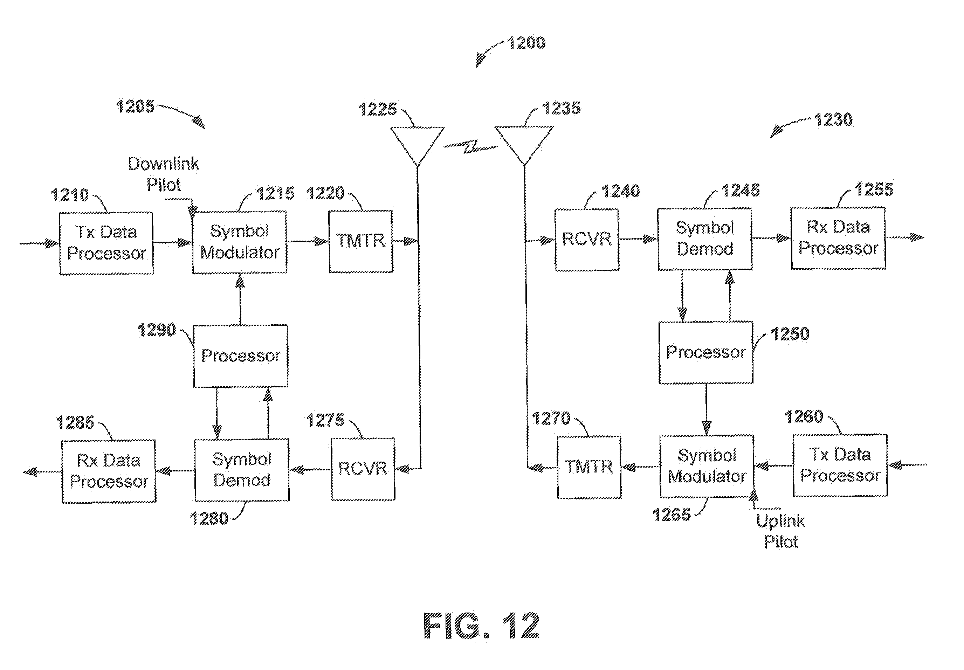

Referring now to **Fig. 12****,** on a downlink, at transmitting device 1205, a transmit (TX) data processor 1210 receives, formats, codes, interleaves, and modulates (or symbol maps) traffic data and provides modulation symbols ("data symbols"). A symbol modulator 1215 receives and processes the data symbols and pilot symbols and provides a stream of symbols. A symbol modulator 1220 multiplexes data and pilot symbols and provides them to a transmitter unit (TMTR) 1220. Each transmit symbol may be a data symbol, a pilot symbol, or a signal value of zero. The pilot symbols may be sent continuously in each symbol period. The pilot symbols can be frequency division multiplexed (FDM), orthogonal frequency division multiplexed (OFDM), time division multiplexed (TDM), frequency division multiplexed (FDM), or code division multiplexed (CDM).

TMTR 1220 receives and converts the stream of symbols into one or more analog signals and further conditions (e.g., amplifies, filters, and frequency up converts) the analog signals to generate a downlink signal suitable for transmission over the wireless channel. The downlink signal is then transmitted through an antenna 1225 to the receiving device 1230. At the receiving device 1230, an antenna 1235 receives the downlink signal and provides a received signal to a receiver unit (RCVR) 1240. Receiver unit 1240 conditions (e.g., filters, amplifies, and frequency down converts) the received signal and digitizes the conditioned signal to obtain samples. A symbol demodulator 1245 demodulates and provides received pilot symbols to a processor 1250 for channel estimation. Symbol demodulator 1245 further receives a frequency response estimate for the downlink from processor 1250, performs data demodulation on the received data symbols to obtain data symbol estimates (which are estimates of the transmitted data symbols), and provides the data symbol estimates to an RX data processor 1255, which demodulates (*i.e.,* symbol de-maps), de-interleaves, and decodes the data symbol estimates to recover the transmitted traffic data.

The processing by symbol demodulator 1245 and RX data processor 1255 is complementary to the processing by symbol modulator 1215 and TX data processor 1210, respectively, at transmitting device 1205. On the uplink, a TX data processor 1260 processes traffic data and provides data symbols. A symbol modulator 1265 receives and multiplexes the data symbols with pilot symbols, performs modulation, and provides a stream of symbols. A transmitter unit 1270 then receives and processes the stream of symbols to generate an uplink signal, which is transmitted by the antenna 1235 to the transmitting device 1205.

At transmitting device 1205, the uplink signal from terminal 1230 is received by the antenna 1225 and processed by a receiver unit 1275 to obtain samples. A symbol demodulator 1280 then processes the samples and provides received pilot symbols and data symbol estimates for the uplink. An RX data processor 1285 processes the data symbol estimates to recover the traffic data transmitted by terminal 1230. A processor 1290 performs channel estimation for each active terminal transmitting on the uplink. Multiple terminals may transmit pilot concurrently on the uplink on their respective assigned sets of pilot subbands, where the pilot subband sets may be interlaced. Processors 1290 and 1250 direct (*e.g.,* control, coordinate, manage, *etc.*) operation at transmitting device 1205 and receiving device 1230, respectively. Respective processors 1290 and 1250 can be associated with memory units (not shown) that store program codes and data. Processors 1290 and 1250 can also perform computations to derive frequency and impulse response estimates for the uplink and downlink, respectively.

For a multiple-access system *(e.g.,* FDMA, OFDMA, CDMA, TDMA, *etc.*)*,* multiple terminals can transmit concurrently on the uplink. For such a system, the pilot subbands may be shared among different terminals. The channel estimation techniques may be used in cases where the pilot subbands for each terminal span the entire operating band (possibly except for the band edges). Such a pilot subband structure would be desirable to obtain frequency diversity for each terminal. The techniques described herein may be implemented by various means. For example, these techniques may be implemented in hardware, software, or a combination thereof. For a hardware implementation, the processing units used for channel estimation may be implemented within one or more application specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, other electronic units designed to perform the functions described herein, or a combination thereof. With software, implementation can be through modules (e.g., procedures, functions, and so on) that perform the functions described herein. The software codes may be stored in memory unit and executed by the processors 1290 and 1250.

For a software implementation, the techniques described herein may be implemented with modules (e.g., procedures, functions, and so on) that perform the functions described herein. The software codes may be stored in memory units and executed by processor components. The memory unit may be implemented within the processor component or external to the processor component, in which case it can be communicatively coupled to the processor component via various means as is known in the art.

What has been described above includes exemplary embodiments. It is, of course, not possible to describe every conceivable combination of components or methodologies for purposes of describing the embodiments, but one of ordinary skill in the art may recognize that many further combinations and permutations are possible. Accordingly, these embodiments are intended to embrace all such alterations, modifications and variations that fall within the spirit and scope of the appended claims. Furthermore, to the extent that the term "includes" is used in either the detailed description or the claims, such term is intended to be inclusive in a manner similar to the term "comprising" as "comprising" is interpreted when employed as a transitional word in a claim.

## Claims

1. A computer-implemented method that regulates energy consumption of a mobile device, the device including an adaptive Rake receiver operatively coupled to an adaptive equalizer component, the device being powered by an energy source, the method comprising:
under the control of one or more computer systems configured with executable instructions,
processing received wireless signals;
identifying available resources of the device, the available resources comprising a plurality of Rake clusters included in the adaptive Rake receiver and powered by the energy source, and a plurality of filter taps powered by the energy source;
dynamically disabling at least one Rake cluster of the plurality of Rake clusters as a function of an estimated signal to noise ratio (SNR), a channel estimation, a probability of demodulation error event, a channel condition, or a searcher result, the dynamic disabling at least one Rake cluster being such that the at least one Rake cluster is no longer powered by the energy source, and the dynamically disabling the at least one Rake cluster resulting in a reduced consumption of energy by the device compared to a consumption of energy by the device before the dynamic disabling;
dynamically determining a number of filter taps to use based on a data rate associated with the wireless signals; and
upon determining dense multipath channel conditions, employing a single time and frequency tracking element within each of the plurality of Rake clusters to track a time and frequency drift of the Rake cluster.

2. The computer-implemented method of claim 1, further comprising monitoring a plurality of parameters in the device and utilizing one or more switching components to selectively disable or enable identified device resources.

3. The computer-implemented method of claim 2, wherein the parameters include inputs or data that define desired operating conditions of the device, wherein the desired operating conditions include signal or data thresholds, quality of service (QoS) conditions, signal to noise ratio (SNR) information, or resource utilization information.

4. The computer-implemented method of claim 1, further comprising employing the device in a direct sequence spread spectrum type ultra wideband (UWB) communication system.

5. The computer-implemented method of claim 1, further comprising selectively enabling or disabling resources based on open loop controls or closed loop controls.

6. The computer-implemented method of claim 5, further comprising applying course receiver adjustments via the open loop controls.

7. The computer-implemented method of claim 6, further comprising measuring a signal-to-noise ratio of incoming received samples and performing a course adjustment of device resources.

8. The computer-implemented method of claim 5, the closed loop controls processing energy per bit to thermal noise density (Eb/No), Received Signal Strength Indicator (RSSI), Block Error Rate (BLER), Packet Error Rate (PER), Signal-to-Noise Ratio (SNR), Link Quality Indicator (LQI), or Bit Error Rate (BER), to enable a desired quality of service.

9. The computer-implemented method of claim 1, further comprising organizing the receiver into groups of Rake resources having K clusters, with each cluster including L fingers, wherein K and L are positive integers.

10. The computer-implemented method of claim 9, further comprising employing switching logic for enabling or disabling individual clusters and enabling or disabling individual fingers within a given cluster.

11. The computer-implemented method of claim 10, further comprising determining switching requirements based on a receiver channel type or processing gain.

12. The computer-implemented method of claim 10, further comprising determining a number of clusters to use and a number of fingers within a cluster to use to achieve a desired demodulation performance.

13. The computer-implemented method of claim 1, further comprising determining analog to digital (A/D) conversion requirements for a received wireless signal, and wherein the dynamically disabling comprises enabling or disabling resources associated with the determined A/D conversion requirements based upon detected conditions for the received wireless signal.

14. The computer-implemented method of claim 13, further comprising determining a word length (number of bits) for an analog to digital converter (ADC) based on an estimate of a received signal-to-noise ratio (SNR).

15. The computer-implemented method of claim 14, further comprising scaling the ADC word length based on the SNR.

16. The computer-implemented method of claim 15, further comprising reducing the word length of the ADC based on the received SNR.

17. The computer-implemented method of claim 16, further comprising generating a control that indicates a number of bits to be used by the ADC.

18. The computer-implemented method of claim 17, further comprising employing large processing gains to minimize ADC bit width requirements.

19. The computer-implemented method of claim 14, further comprising adjusting an ADC sampling rate in view of incoming signal conditions.

20. The computer-implemented method of claim 19, further comprising over-sampling a received signal during a preamble portion of the signal during which timing is adjusted.

21. The computer-implemented method of claim 20, further comprising determining a sampling rate after the preamble portion of the signal.

22. The computer-implemented method of claim 1, the set of taps are associated with a delay unit, a multiply unit and a summing unit clocked at an input symbol rate.

23. The computer implemented method of claim 1, further comprising controlling variable forward taps and variable feedback taps.

24. A wireless communications device, comprising:
a modem component that includes a receiver component and a transmitter component to process wireless signals,
an adaptive equalizer component configured to process received wireless signals;
one or more resources configured to control operations of the modem component, the one or more resources comprising a plurality of Rake clusters included in an adaptive Rake receiver powered by an energy source;
a resource manager configured to selectively enable or disable at least one Rake cluster of the plurality of Rake clusters in view of detected channel conditions at the modem, wherein when the at least one Rake cluster is selectively disabled, the at least one Rake cluster is no longer powered by the energy source, which results in a reduced consumption of energy by the adaptive Rake receiver compared to a consumption of energy by the adaptive Rake receiver before selectively disabling the at least one Rake cluster;
a tap manager configured to select a number of filter taps in the adaptive equalizer based on a data rate and a channel condition associated with the received wireless signals; and
a single time and frequency tracking element employed within each of the plurality Rake clusters to track a time and frequency drift of the Rake cluster upon determining dense multipath channel conditions.

25. The device of claim 24, further comprising at least one of a cluster manager, a word length manager, and a sampling manager, to selectively enable or disable the one or more resources.

26. A non-transitory computer-readable storage medium having instructions stored thereon, the instructions configured to cause the computer to:
store one or more thresholds relating to parameters of a wireless network, the parameters relating to at least a data rate and a channel estimation or a signal to noise ratio (SNR);
compare received signal conditions to the one or more thresholds; and
adjust component resources of a wireless receiver based in part on the received signal conditions and the one or more thresholds,
wherein the component resources comprise a plurality of Rake clusters included in an adaptive Rake receiver and an adaptive equalizer component powered by an energy source, and wherein the instructions are configured to:
cause the computer to adjust the component resources;
cause the computer to disable at lease on Rake cluster of the plurality of Rake clusters such that the at least one Rake cluster is no longer powered by the energy source, the disabling the at least one Rake cluster resulting in a reduced consumption of energy by the adaptive Rake receiver compared to a consumption of energy by the adaptive Rake receiver before disabling the at least one Rake cluster;
cause the computer to determine a number of equalizer taps to use based on the data rate; and
cause the single time and frequency tracking element employed in each of the plurality of Rake clusters to track a time and frequency drift to the Rake cluster upon determining dense multipath channel conditions.

27. A wireless communications system, comprising:
means for determining available resources of a device, the device comprising an adaptive Rake receiver powered by an energy source, an adaptive Rake receiver and a plurality of filter taps included in the adaptive equalizer component;
means for enabling or disabling at least one Rake cluster of the plurality of Rake clusters as a function of an estimated signal to noise ratio (SNR), a channel estimation, a probability of demodulation error event, a channel condition, or an acquisition result, wherein when the at least one Rake cluster is dynamically disabled, the at least one Rake cluster is no longer powered by the energy source, which results in a reduced consumption of energy by the adaptive Rake received compared to a consumption of energy by the adaptive Rake receiver before dynamically disabling the at least one Rake cluster;
means for enabling the number of filter taps to use based on a data rate of received wireless communications; and
means within each Rake cluster for tracking a time and frequency drift of the Rake cluster upon determining dense multipath channel conditions.

28. A method for reducing power consumption of an adaptive Rake component and an adaptive equalizer component in a wireless mobile device, comprising:
obtaining a probability of demodulation error event;
receiving a wireless communication signal at a first data rate;
determining a level of inter-symbol interference associated with the wireless signal;
in response to determining that the level of intersymbol interference is dominant,
implementing the adaptive equalizer component and dynamically altering a number of filter taps to be used based on the obtained probability of demodulation error event.
